Europäisches Patentamt

European Patent Office

Office européen des brevets

(11) Publication number: **0 169 078**
A2

# EUROPEAN PATENT APPLICATION

(21) Application number: 85305169.6

(51) Int. Cl.⁴: **H 01 L 39/14**

(22) Date of filing: 19.07.85

(30) Priority: 19.07.84 JP 148610/84

(43) Date of publication of application: 22.01.86
Bulletin 86/4

(84) Designated Contracting States: DE FR GB

(71) Applicant: Kabushiki Kaisha Toshiba, 72, Horikawa-cho Saiwai-ku, Kawasaki-shi Kanagawa-ken 210 (JP)

(72) Inventor: Koizumi, Misao c/o Patent Division, Kabushiki Kaisha Toshiba 1-1 Shibaura 1-chome, Minato-ku Tokyo 105 (JP)
Inventor: Murase, Satoru c/o Patent Division, Kabushiki Kaisha Toshiba 1-1 Shibaura 1-chome, Minato-ku Tokyo 105 (JP)

(74) Representative: Freed, Arthur Woolf et al, MARKS & CLERK 57-60 Lincoln's Inn Fields, London WC2A 3LS (GB)

(54) Superconductor prepared from Nb3Sn compound.

(57) A superconductor constructed through the steps of embedding a plurality of Nb wires (22) into a Cu-Sn alloy region (26), inserting the mass into a vanadium cylindrical wall (28), placing said latter mass into a copper pipe (32), and applying heat treatment to produce a $Nb_3Sn$ compound superconductor (24) around the Nb wire (22). A $V_3Sn$ compound is formed inside the vanadium barrier wall (28) of the said superconductor. Since, however, the $V_3Sn$ compound (30) does not indicate superconductivity at the liquefied helium temperature, A.C. loss is reduced to a negligible extent, even when impressed with pulse current or A.C. current.

- 1 -

## Superconductor prepared from $Nb_3Sn$ compound

This invention relates to a superconductor prepared from $Nb_3Sn$ compound which is suitable for a pulse or alternating magnet.

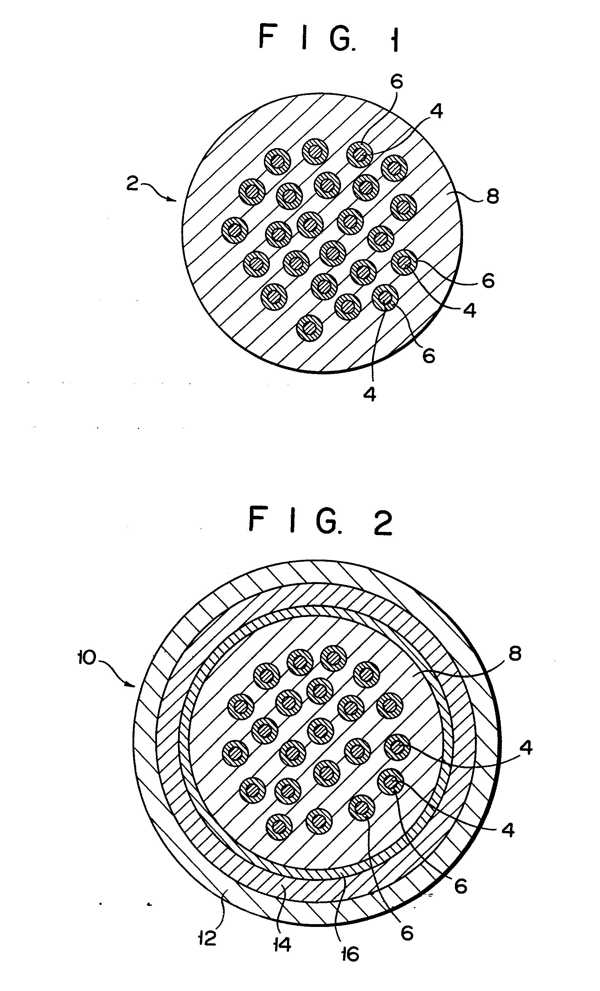

The $Nb_3Sn$ superconductor is generally manufactured through the steps of inserting a plurality of Nb rods into a Cu-Sn alloy pipe to form a multi-core rod, drawing the multi-core rod into an extremely fine wire by means of a die and, later, heat treating the fine drawn wire. The heat treatment causes the Sn component of the Cu-Sn alloy to react with Nb, thereby producing $Nb_3Sn$ compound. Consequently, as shown in Fig. 1, numerous Nb wires 4 are embedded in the Cu-Sn alloy region 8. Thus, a superconductor 2 which comprises numerous superconducting regions 6, each of which consists of a cylindrical $Nb_3Sn$ compound superconducting region 6 surrounding the Nb wire 4, is manufactured.

However, the above-mentioned conventional superconductor 2 suffers from the drawback whereby the superconducting regions 6 which are surrounded by a Cu-Sn alloy region 8 of high electric resistance are reduced in stability. In other words, if the superconducting region 6 is, for some reason or other, quenched into the type for normal electric conductivity, current undesirably runs through the Cu-Sn alloy region 8, thereby causing said Cu-Sn alloy of high resistivity to release great heat and subsequently burn the superconductor.

To resolve the above-mentioned drawbacks, a superconductor 10, shown in Fig. 2, comprises a Cu stabilizing region 12, of low electric resistivity, which occupies the outermost peripheral region of said superconductor 10. In this case, however, heat treatment is likely to cause the Sn component of the Cu-Sn alloy region 8 to diffuse into the Cu stabilizing region 12, thereby causing said Cu stabilizing region 12 to be contaminated with Sn and to have high resistance.

To avoid the occurrence of such an undesirable event, an Nb barrier wall 14 is set between the Cu stabilizing region 12 and the Cu-Sn alloy region 8. Unfortunately, when the superconductor 10 is subjected to heat treatment, the Nb component of said barrier wall reacts with the Sn component of the Cu-Sn alloy region 8, generating a $Nb_3Sn$ region 16 inside of said barrier wall 14 (that is, in the border region between the barrier wall 14 and Cu-Sn alloy region 8). This $Nb_3Sn$ region 16 indicates as great a superconductivity as the superconducting region 6, maintained at the liquid helium temperature of 4.2°K. When alternating current or pulse voltage is supplied to the superconductor 10, hysteresis loss appears in a region, indicating superconductivity.

The hysteresis loss varies with the diameter of said superconducting region. Though negligible in the superconducting region 6, hysteresis loss becomes considerably prominent in the $Nb_3Sn$ region 16. Consequently, the superconductor 10, in which a large diameter $Nb_3Sn$ region 16 is undesirably formed, is accompanied by the drawback that A.C. loss becomes noticeable due to the hysteresis loss.

It is, accordingly, the object of this invention to provide a superconductor which is prepared from an $Nb_3Sn$ compound which, even when impressed with pulse current or A.C. current or pulse or AC·magnetic field, experiences a reduction in A.C. loss, making it, therefore, as a result of its inherent stability applicable for practical use.

To attain the above-mentioned object, this invention provides a superconductor prepared from an $Nb_3Sn$ compound, which comprises:

a Cu-Sn alloy region;

a plurality of superconducting regions which are prepared from $Nb_3Sn$ compound and provided in said Cu-Sn alloy region;

at least one stabilizing region having a lower resistivity than said Cu-Sn alloy; and

at least one barrier wall which is prepared from vanadium and set between the Cu-Sn alloy region and the stabilizing region.

With a superconductor embodying this invention, the barrier wall is prepared from vanadium (V). When, therefore, heat treatment is applied, a V-Sn compound is produced near the barrier wall. However, this V-Sn compound does not indicate superconductivity at the liquid helium temperature (4.2°K). Therefore, superconductivity is indicated only by $Nb_3Sn$ compound superconducting regions surrounding the Nb wires. Even when, therefore, impressed with A.C. current or pulse current or pulse or AC magnetic field, the subject superconductor has reduced hysteresis loss. Concretely speaking, the A.C. loss occurring in the subject superconductor is reduced to less than half of what is observed in the conventional superconductor employing an Nb barrier wall. Further even when part of the superconducting region is quenched into the type for normal conductivity, current flows through a Cu stabilizing region, preventing undue accumulation of heat, and thereby ensuring the stable application of the subject superconductor. Moreover, Cu contamination, arising during heat treatment, is suppressed by the vanadium barrier wall.

This invention can be more fully understood from the following detailed description when taken in conjunction with the accompanying drawings, in which:

Figs. 1 and 2 are cross sectional views of the conventional superconductors;

Fig. 3 is a cross sectional view of a superconductor embodying this invention;

Fig. 4 graphically indicates the effect of the superconductor of the invention; and

Figs. 5 and 6 are cross sectional views of superconductors according to other embodiments of the invention.

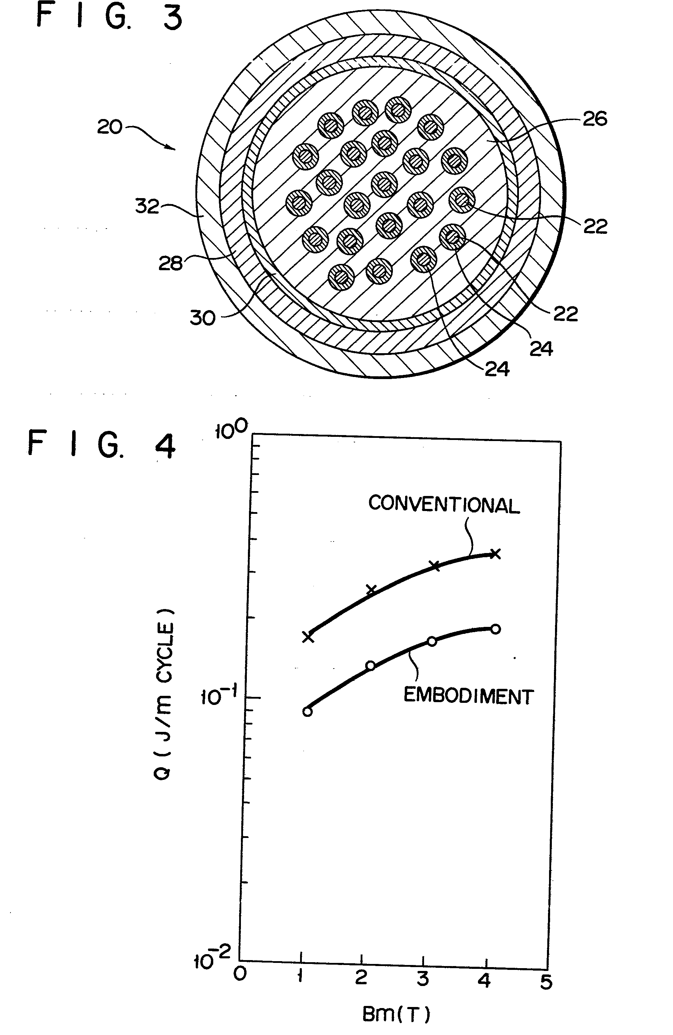

Fig. 3 is a cross sectional view of a superconductor 20 according to a first embodiment of this invention. With this superconductor 20, 925 Nb wires 22, having a diameter of about 10 microns, are embedded in a Cu-Sn alloy region 26 containing 13% by weight of Sn, and having a diameter of about 700 microns. This Cu-Sn alloy region 26 is enclosed by a cylindrical barrier wall 28 whose outer diameter measures about 800 microns, and whose inner diameter measures 700 microns. Said cylindrical barrier wall 28 is further surrounded by a cylindrical stabilizing region 32 having an outer diameter of about 1 mm and an inner diameter of about 800 microns. An Nb$_3$Sn compound superconducting region 24 is formed around each Nb wire 22 (that is, the boundary between the Nb wire 22 and Cu-Sn alloy region 26). The cylindrical barrier wall 28 is prepared from vanadium (V). Formed inside cylindrical barrier wall 28 (that is, the boundary between said barrier wall 28 and Cu-Sn alloy region 26) is V-Sn region 30. The outermost stabilizing region 32 is prepared from Cu.

The superconductor 20 embodying this invention, and being of the above described construction, is manufactured through the following steps. First, an Nb wire having a diameter of 30 to 40 mm is inserted into a Cu-Sn alloy pipe whose inner diameter is slightly larger than the diameter of said Nb wire, and whose outer diameter is 60 to 80 mm. Later, a single core wire having a diameter of about 10 mm is produced by a drawing process. Thereafter, 925 said single core wires are bound together to provide a larger single core wire. Said larger single core wire is inserted into a Cu-Sn alloy pipe having an outer diameter of 80 mm and an inner diameter of 70 mm. Drawing is applied again to provide a multi-core wire consisting of 925 Nb wires embedded in the Cu-Sn alloy. Said multi-core wire is inserted into a vanadium pipe which, subsequently, is enclosed in a Cu pipe. A rod member constructed by inserting a vanadium pipe between the Cu pipe and the multi-core wire is drawn to provide a wire having an outer diameter of about 1 mm. This wire is subjected to heat treatment at 700°C for 50 hours. As a result, the Sn component of said Cu-Sn alloy reacts with the Nb component of the Nb wire, thereby providing an $Nb_3Sn$ compound. As shown in Fig. 3, therefore, superconducting regions 24 prepared from $Nb_3Sn$ alloy are formed around the Nb wires 22. The above-mentioned heat treatment causes the vanadium of the barrier wall 28 to react with the Sn component of the Cu-Sn alloy region 26 to produce a V-Sn compound region 30.

With the superconductor 20 of this invention, constructed as described above, an $Nb_3Sn$ superconducting region 24 indicates a sufficiently high superconductivity at the liquid helium temperature (4.2°K). Current supplied to the superconductor 20 runs through said $Nb_3Sn$ superconducting region 24. This superconducting region 24 is low in hysteresis loss because of its small diameter. Conversely, the $V_3Sn$ compound indicates no superconductivity at the liqued helium temperature (4.2°K), such that no current runs through said V-Sn region 30. The occurrence of hysteresis loss therein is, therefore, suppressed.

Even when, therefore, pulse voltage or AC voltage is impressed on the superconductor 20, the AC loss is remarkably low. During heat treatment, the diffusion transfer of Sn through the Cu-Sn alloy region 26 is prevented by the vanadium barrier wall 28. Consequently, the Cu stabilizing region 32 is not contaminated by Sn. When, therefore, part of the superconducting region 24 is quenched into the normal conductivity, the Cu stabilizing region 32 exhibits a functional capacity as a region allowing for the passage of diverted current stream. For this reason, the subject superconductor 20 has a high stability.

Fig. 4 graphically compares the A.C. loss occurring in the superconductor 20 embodying this invention with that observed in the conventional superconductor 10 (Fig. 2) involving an Nb barrier wall 14. Referring to Fig. 4, the ordinate shows the unit length of the superconductors 10, 20, and the A.C. loss Q per cycle (J/m-cycle). The abscissa denotes the maximum magnitude Bm(T) of a magnetic field supplied to the superconductors 10, 20. The A.C. loss was determined by the magnetic method whereby the superconductors 10, 20 were supplied with a pulse magnetic field whose magnitude was changed as $0(T) \rightarrow Bm(T) \rightarrow 0(T)$ at the liquid helium temperature (4.2°K). The rate of the change in the magnetic field was fixed at B = 0.05 (T/S), and A.C. loss was determined with respect to the maximum magnitude Bm(T) of a magnetic field supplied to the superconductors 10, 20, ranging between 1(T) and 4(T) (where T represents tesla).

As seen from Fig. 4, the A.C. loss occurring in the superconductor 20 embodying this invention was reduced to about half that observed in the conventional superconductor 10, proving that the present invention can provide a superconductor of extremely low A.C. loss. Referring to A.C. properties such as the critical current value and recovered current, the superconductor of this invention, involving the vanadium barrier wall, indicated substantially the same data as the conventional superconductor using the niobium (Nb) barrier wall. This means that the superconductor of the invention has a very high stability.

In the foregoing embodiment, the stabilizing region 32 was prepared from copper (Cu). However, said stabilizing region 32 can be formed of, for example, aluminum (Aℓ) or silver (Ag) which have a lower resistivity than the Cu-Sn alloy. Further, in the above-mentioned embodiment, the superconducting region 24 was prepared from $Nb_3Sn$ compound. The high magnetic field property of this subject superconductor can be improved by adding 1 to 2% by weight of Ti to said $Nb_3Sn$ compound. This improvement is substantiated by the fact that, without Ti, the critical current density Ic drops, whereas the magnetic field intensity B exceeds 12 telas. In contrast, when Ti is added, the critical magnetic field in which the critical current density Ic generally falls, acquires a higher magnetic density, thereby sustaining a high critical current density until such time as a high magnetic field is required. The superconductor of the above-mentioned feature can be manufactured by applying a pipe of a Ti-bearing Cu-Sn alloy consisting of 85% by weight of Cu, 13% by weight of Sn and 2% by weight of Ti or a pipe of an Nb-Ti alloy consisting of 99% by weight of Nb and 1% by weight of Ti, or both pipes.

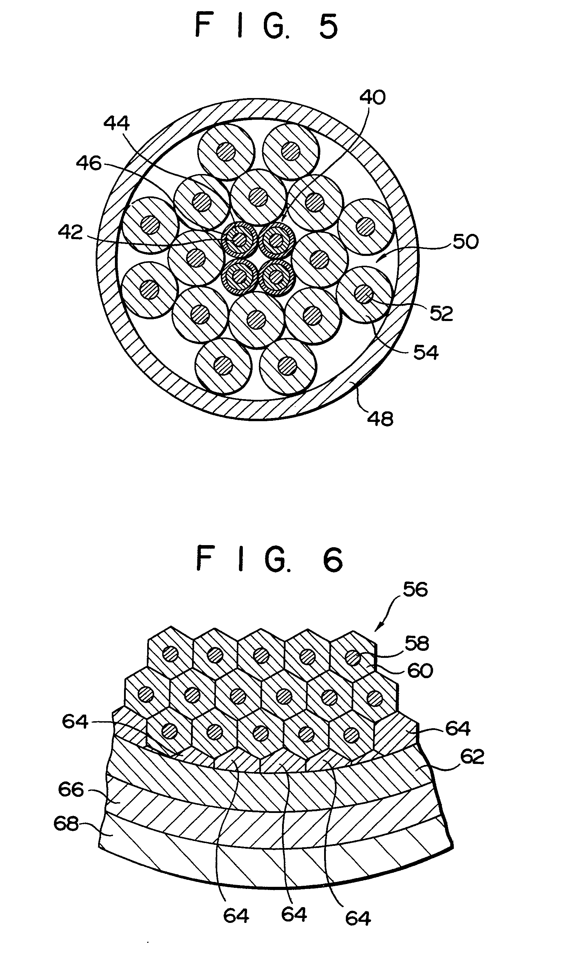

In the aforementioned embodiment, Nb wires are embedded in the Cu-Sn alloy which, in turn, is surrounded, successively, by the vanadium barrier wall and Cu stabilizing region. The present invention, however, is not limited to the above-mentioned construction of a superconductor, but, rather, admits of various modifications. For instance, as shown in Fig. 5, a plurality of stabilizing Cu wires are surrounded by a partitioning vanadium pipe 44. Said vanadium pipe 44 is enclosed in a Cu-Sn alloy pipe 46 to provide a first group of wires 40. Conversely, a plurality of niobium (Nb) wires 52 are wrapped in a Cu-Sn alloy pipe 54, producing a second group of wires 50. This second group of wires 50 is bundled around the first group of wires 40. Both groups of wires 40, 50 are then inserted into a Cu-Sn alloy pipe 48. Later, drawing and heat treatment are applied to provide a superconductor wire including a plurality of stabilizing regions occupying the control portion, and a further plurality of $Nb_3Sn$ superconducting regions surrounding said plural stabilizing regions.

Description may now be made, with reference to Fig. 6, of the method of manufacturing a superconductor according to a second embodiment of this invention.

A single core wire 56 is manufactured by inserting a niobium (Nb) wire 58 into a Cu-Sn alloy pipe 60, and drawing this composite wire through a metal die having a hexagonal cross section. A compact bundle of said plural hexagonal single core wires 56 is inserted into a Cu-Sn alloy pipe 62. Cu-Sn alloy fillers 64 are interposed in the interstices defined between the Cu-Sn alloy pipe 62 and the plural single core wires 56. As a result, the Cu-Sn alloy 62 and Nb wires 58 are compactly fitted into the cylindrical pipe 62. Later, the cylindrical pipe 62 is inserted into a vanadium barrier pipe 66 which is subsequently wrapped in a stabilizing Cu pipe 68. Thereafter, drawing and heat treatment are applied to manufacture a superconductor according to the second embodiment of this invention. In this case, the various wire members are fitted into the surrounding pipes with greater compactness, thus providing a high quality superconductor.

As has been conventionally practiced, the superconductor may be twisted in order to reduce the coupling loss resulting from the coupling current. Moreover, the sectional shape of the superconductor is not limited to a circular one. It may be rectangular, in which case the advantages of the invention would not be impaired. More specifically, the superconductor may be so shaped in the drawing process and then be subjected to a low-temperature heat treatment.

Claims:

1. An $Nb_3Sn$ compound superconductor comprising:

a Cu-Sn alloy region (26);

a plurality of superconducting regions (24) which are prepared from $Nb_3Sn$ compound and embedded in the Cu-Sn alloy region (26); and

at least one stabilizing region (32) having a lower resistivity than the Cu-Sn alloy region (26);

characterized by comprising

at least one barrier wall (28) which is prepared from vanadium and set between the Cu-Sn alloy region (26) and the stabilizing region (32).

2. The $Nb_3Sn$ compound superconductor according to claim 1, characterized in that the stabilizing region (32) is composed of copper.

3. The $Nb_3Sn$ compound superconductor according to claim 1, characterized in that the superconducting region (24) is embedded in a round columnar Cu-Sn alloy region (26), and the Cu-Sn alloy region is enclosed in a cylindrical barrier wall (28), which, in turn, is surrounded by a cylindrical stabilizing region (32).

4. The $Nb_3Sn$ compound superconductor according to claim 1, characterized in that the superconducting region (52) and stabilizing regions (42) are embedded in the Cu-Sn alloy region, the stabilizing region being covered with a barrier wall.

5. The $Nb_3Sn$ compound superconductor according to claim 3, characterized in that the superconducting region (24) is formed through the steps of:

inserting a niobium wire into a smaller diameter Cu-Sn alloy pipe;

drawing the mass into a single-core wire (56);

inserting a plurality of single-core wires into a larger diameter Cu-Sn alloy pipe (62);

compacting the larger diameter Cu-Sn alloy pipe (62) into a vanadium pipe;

placing said vanadium pipe into said Cu pipe;

drawing the concentrically inserted mass to provide a plural-core wire; and

heat-treating the plural-core wire to cause the Sn component of said Cu-Sn alloy to combine with the Nb wire, thereby providing $Nb_3Sn$ compound.

6. The $Nb_3Sn$ compound superconductor according to claim 5, characterized in that the single-core wire is made into a round columnar form.

7. The $Nb_3Sn$ compound superconductor according to claim 5, characterized in that the single-core wire (56) is made hexagonal.

8. The $Nb_3Sn$ compound superconductor according to claim 7, characterized by being constructed by compactly inserting a plurality of the hexagonal single-core wires (56) into a Cu-Sn alloy pipe (62) and enclosing an interstice, defined between the Cu-Sn alloy pipe (62) and the plural single-core wires (56), with a Cu-Sn alloy filler (64).

9. The $Nb_3Sn$ compound superconductor according to claim 4, characterized in that the superconducting region is formed through the steps of:

inserting copper wires (42) into a vanadium pipe (46);

drawing the mass into a first single-core wire (40);

inserting Nb wires (52) into a smaller diameter Cu-Sn alloy pipe (54);

drawing the mass to provide second single-core wires (50);

inserting the first and second single-core wires (40, 50) into a larger diameter Cu-Sn alloy pipe (48);

drawing the mass to provide plural-core wires; and

heat treating said plural-core wires to cause the Sn component of said Cu-Sn alloy to combine with the Nb material of said Nb wire, thereby producing an $Nb_3Sn$ compound.

F I G. 1

F I G. 2

# FIG. 3

# FIG. 4

# F I G. 5

# F I G. 6